Europäisches Patentamt

(19) European Patent Office

Office européen des brevets

(11) Publication number: **0 224 418 B1**

# EUROPEAN PATENT SPECIFICATION

(12)

(45) Date of publication of patent specification :
23.01.91 Bulletin 91/04

(51) Int. Cl.⁵ : **H01L 27/10, G11C 17/00**

(21) Application number : **86402644.8**

(22) Date of filing : **28.11.86**

(54) **A programmable element for a semiconductor integrated circuit chip.**

(30) Priority : **29.11.85 JP 268539/85**

(43) Date of publication of application :
**03.06.87 Bulletin 87/23**

(45) Publication of the grant of the patent :
**23.01.91 Bulletin 91/04**

(84) Designated Contracting States :
**DE FR GB**

(56) References cited :
US-A- 3 576 549
US-A- 3 793 090
IBM TECHNICAL DISCLOSURE BULLETIN,
vol. 14, no. 11, April 1972, pages 3348-3350,
New York, US; S.A. ABBAS et al.:
"Improvement of the gate-region integrity in
FET devices"
PATENT ABSTRACTS OF JAPAN, vol. 6, no.
189 (E-133)[1067], 28th September 1982 &
JP-A-57-103 348

(73) Proprietor : **FUJITSU LIMITED**
**1015, Kamikodanaka Nakahara-ku**
**Kawasaki-shi Kanagawa 211 (JP)**

(72) Inventor : **Nawata, Takahiro**
**3, Azamino 4-chome Midori-ku**
**Yokohama-shi Kanagawa 227 (JP)**
Inventor : **Wada, Kunihiko Pakusaido**
**Musashikosugi 403**
**658-1, Miyauchi Nakahara-ku**
**Kawasaki-shi Kanagawa 211 (JP)**
Inventor : **Sato, Noriaki**
**28-21, Tsurukawa 4-chome**
**Machida-shi Tokyo 194-01 (JP)**

(74) Representative : **Descourtieux, Philippe et al**
**CABINET BEAU de LOMENIE 55 rue**
**d'Amsterdam**
**F-75008 Paris (FR)**

## Description

The present invention relates to a programmable element for a semiconductor IC (integrated circuit) chip.

An element utilizing the electrical breakdown of an insulating layer thereof for storing information has been proposed. That is, a conduction established in the insulating layer by electrical breakdown is assigned to either logical "1" or "0" in binary notation. Such a programmable element was first disclosed by one of the co-inventors of the present invention and is described in the Japanese Patent No.1195815 of March 12, 1984. Other subsequent patent applications relating to programmable elements of this type have been filed, including a Japanese patent application published under No. 60-74669, April 26, 1985, disclosing the structure and fabrication processes of a PROM (programmable read only memory) and a mask ROM, and a United States patent application filed September 2, 1986, disclosing a structure of a PROM and a write operation for protecting non-selected memory cells from erroneous write-in. A comprehensive presentation of the programmable element was given at the 1985 IEDM (International Electron Device Meeting), Washington, DC., under the title of "A NEW PROGRAMMABLE CELL UTILIZING INSULAR BREAKDOWN" by the co-inventors.

The programmable element, which is hereinafter named BIC (Breakdown of Insulator for Conduction) cell, has a structure comprising an insulating layer formed between a couple of electrode layers. Typical applications of BIC cell include memory cells for a PROM (programmable read only memory) and switching means for a redundancy circuit (a row or column of a memory cell array) in a RAM (random access memory). In a PROM, for example, each of BIC cells is formed on a semiconductor substrate so as to be associated with a corresponding one of arrayed transistors or diodes formed in the substrate, and thus, constitutes a memory cell disposed in a matrix arrangement. The memory cell is programmed when the insulating layer of the BIC cell is broken down by a voltage applied thereto. In this memory cell, the BIC cell can be formed directly on the associated transistor or diode in the manner that the impurity diffusion layer for the drain or collector of the transistor, for instance, is used as one of the electrodes of the BIC cell. This means that a BIC cell can have a structure stacked on each MIS FET, constituting a memory cell together, and hence, does not require a particular chip area therefor in contrast with prior art programmable elements such as fuses or PN junctions used in a conventional PROM. Hence, an increase in the packing density of the PROM can be achieved by using BIC cells.

The BIC cell is designed so as to have a programming voltage, i.e. breakdown voltage of the insulating layer, which is in a predetermined voltage range. That is, the upper limit of the breakdown voltage must be lower than that of other circuit elements, typically, the PN junction formed by the aforesaid N$^+$ impurity diffusion layer and the P-type substrate, for example. The lower limit of the breakdown voltage must be higher than the normal operating voltage, the read-out voltage of a memory cell, for example, in order to avoid erroneous programming of non-selected memory cells during the read operation. Accordingly, the breakdown voltage of the insulating layer is to be in the range from 10 to 20 volts, in general.

The insulating layer of prior art BIC cells is formed by oxidizing a doped-polysilicon layer. The above-mentioned Japanese patent discloses that a silicon-oxide layer formed from a doped-polysilicon layer implanted with arsenic atoms to a dose of about $1 \times 10^{16}/cm^2$ exhibits a breakdown voltage of 30 to about 50 volts for a thickness of 120nm.

However, the breakdown voltage of a silicon-oxide insulating layer formed by oxidizing such a doped-polysilicon layer is relatively high as 25 volts and distributes with a range as broad as $\pm 7$ volts. Further, the resistance of the BIC cells thus fabricated has a relatively high value ranging between 1 kohms and 10 kohms. This high resistance is provided by the polysilicon layer which acts as a resistor after the write operation. The high resistance inevitably results in a low speed in the read operation of memory cells each comprising a programmed BIC cell.

On the other hand, a silicon-oxide layer formed by thermally oxidizing a single-crystal-silicon substrate cannot be used for a BIC cell, as briefly discussed below. The electric field threshold for the intrinsic breakdown of silicon dioxide ($SiO_2$) such as silica is approximately 10 MV/cm. Therefore, it seems that a programming voltage of 10 to 15 volts in the BIC cell could easily be achieved by creating a silicon-dioxide layer having a thickness of 10 to 15 nm. However, there is a mode of breakdown which is considered to be due to a certain type of lattice defect in the silicon-oxide layer, and lower breakdown thresholds distributing around 3 MV/cm are revealed. This means that BIC cells in a non-selected memory cell should erroneously be programmed by a low voltage, such as 5 volts, applied to the silicon-oxide layer during the readout operation, for example.

It is, therefore, an object of the present invention to provide a programmable element or BIC cell which can be stably programmed by a predetermined write-in voltage.

It is another object of the present invention to provide a BIC cell having an improved insulating layer.

According to the invention, these and other objects are reached by a programmable element comprising : a lower electrode layer formed on a substrate ; an insulating layer composed of at least two dielectric material films, for example a relatively thin silicon-dioxide film and a relatively thick silicon-nitride film, the dielectric material films being successively formed on the lower electrode layer; and an upper electrode layer formed on the insulating layer, the upper electrode being separated from the lower electrode by the insulating layer, such that the programmable element is provided with a conduction path between the lower and upper electrodes when a voltage capable of causing an electrical breakdown in the insulating layer is applied between the lower and upper electrodes.

Further objects, features and advantages of the present invention will become more apparent from the following description made with reference to the accompanying drawings wherein:

Fig. 1 is a cross-section illustrating a fundamental configuration of a prior art BIC cell;

Fig. 2 is a cross-section illustrating another configuration of a prior art BIC cell;

Fig. 3 is a cross-section illustrating a BIC cell comprising an $N^+$ region which is commonly shared with a MIS FET formed together on a substrate;

Fig. 4 is a cross-section schematically illustrating a conduction path formed in the insulating layer of a programmed BIC cell;

Figs. 5 and 6 are equivalent circuits respectively corresponding to a BIC cell before programming and after programming;

Figs. 7A to 7G are cross-sections illustrating a method for fabricating a BIC cell according to an embodiment of the present invention; and

Fig. 8 is a cross-section illustrating a BIC cell according to another embodiment of the present invention.

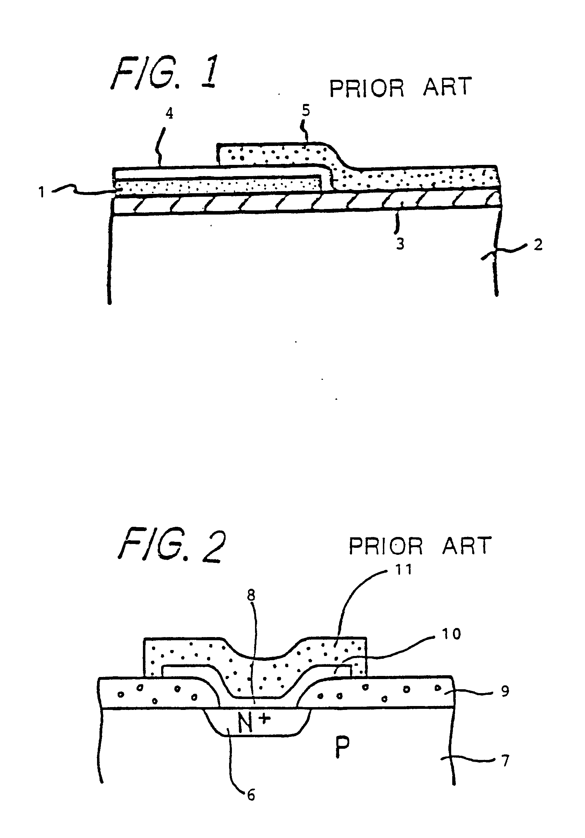

Fig. 1 is a cross-section illustrating a fundamental configuration of a prior art BIC cell comprising a lower electrode 1 formed on a substrate 2 such as a silicon IC chip. An insulating layer 3 is formed as shown in Fig. 1 so as to electrically isolate the electrode 1 from the substrate 2. Another insulating layer 4 is formed to cover electrode 1. The insulating layer 4 is a silicon-dioxide layer formed by oxidizing the electrode 1 which is made of a polysilicon layer, for example. An upper electrode 5 is formed as shown in Fig. 1 so as to overlap the lower electrode 1 with the intervention of the insulating layer 4. The upper electrode 5 can be made of a conventional electrode material such as aluminum (Al), molybdenum (Mo) or platinum (Pt).

If a BIC cell is selected to be programmed, a voltage large enough to cause an electrical breakdown of the insulating layer 4 is applied between the electrodes 1 and 5, hence a conduction path connecting the electrodes is formed in the insulating layer 4. As already mentioned, if the polysilicon layer constituting the electrode 1 is doped with arsenic atoms by an ion implantation, for example, to a concentration up to $1\times10^{16}/cm^2$, a silicon-dioxide layer 4 having a thickness of about 120 nm can be programmed with the application of a voltage of 30 to 50 volts.

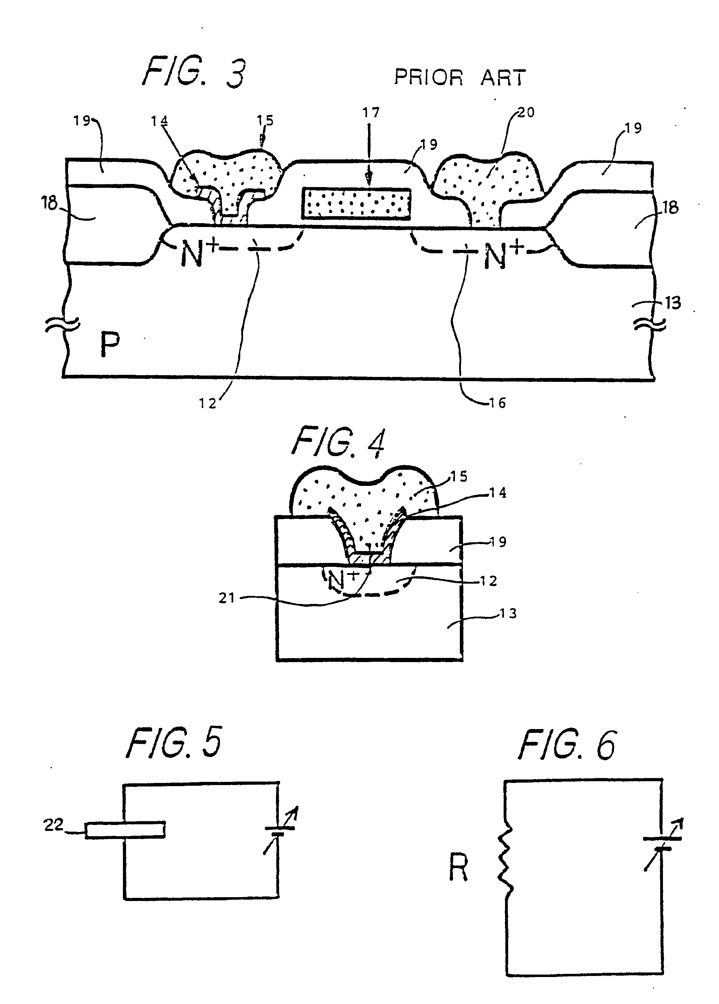

Fig. 2 is a cross-section illustrating another configuration of a prior art BIC cell, with a lower electrode formed by an impurity diffusion layer 6 such as an $N^+$ region formed in a P-type-silicon substrate 7. In this case, an insulating layer 9 having a contact hole 8 to expose the $N^+$ region 6 therethrough is formed on the substrate 7. Another insulating layer 10 is formed to cover the region 6. The insulating layer 10 may be a silicon-dioxide layer of a thermally-oxidized-polysilicon layer (not shown) formed on the region 6, as disclosed in the above-mentioned Japanese patent No.1195815 and patent application No.60-74669. An upper electrode 11 of aluminium, for example, is formed on the insulating layer 10.

The impurity diffusion region 6 as shown in Fig. 2 may be an $N^+$ (or $P^+$) region of a diode or a drain region of a MIS FET (metal insulator semiconductor field effect transistor) formed in a semiconductor substrate. Fig. 3 is a cross-section illustrating such a BIC cell comprising an $N^+$ region commonly shared with a MIS FET, the BIC cell and the MIS FET being formed together on a semiconductor substrate for constituting a memory cell. Referring to Fig. 3, the BIC cell comprises an $N^+$ region 12 formed in a semiconductor substrate 13, an insulating layer 14 formed on the region 12 and an upper electrode 15 formed on the insulating layer 14, and thus, has a configuration essentially similar to the one of the BIC cell of Fig. 2. The $N^+$ region 12 also constitutes the drain region of a MIS FET comprising an $N^+$ source region 16 and a gate electrode 17. Thus, the $N^+$ region 12 is commonly shared by the BIC cell and the MIS FET. In Fig. 3, reference numerals 18, 19 and 20 respectively designate a field oxide layer, an insulting layer and a source electrode. It is obvious from Fig. 3 that there is no need for any incremental chip area for the BIC cell sharing the region 12 with the FET. Thus, the BIC cells can be formed on the semiconductor substrate without decreasing the packing density of the FETs.

The BIC cell is programmed when a voltage pulse is applied between the lower electrode and the upper electrode so as to cause a breakdown in the insulating layer therebetween. Thus, a conduction path 21 composed of the upper electrode of aluminum, for example, is established between the electrodes, as shown in Fig. 4. Like reference numerals designate like or corresponding parts in Figs. 3 and 4. Figs. 5 and 6 are equivalent circuits respectively corresponding to a BIC cell before programming and after programming. Before programming, the insulating layer 22 of a BIC cell is non-conductive, as shown in Fig. 5. While, once a breakdown is caused therein, the circuit of Fig. 5 changes to a conductive state represented by a resistance R, as shown in Fig. 6. If the non-conductive state is assigned to logical "0" and the conductive state to logical "1", the insulating layer of a BIC cell to be programmed as logical "1" is broken down by a voltage pulse.

When a plurality of such cells are disposed in X and Y directions so as to form a matrix arrangement, the cells which are programmed store logical "1" data and non-programmed cells store logical "0" data, thus forming a programmable read only memory (PROM). The data are read out by applying a read out voltage to each of the cells and detecting a current flowing through each cell. Cells each having a detected current flowing therethrough are defined as to be in logical "1" state and cells having no detected current are defined as to be in logical "0" state.

A BIC cell as shown in Fig. 2 can be used as a switching means for a redundant circuit in a semiconductor integrated circuit. When a memory cell array of an integrated semiconductor memory device includes a defective memory cell, the array can be replaced by an equivalent redundant memory cell array provided in the memory device. Referring to a BIC cell as shown in Fig. 2, if the $N^+$ region 6 has been internally connected to a redundant memory cell array and the upper electrode 11 is connected to a read/write circuit, the redundant memory cell array can be activated by causing a breakdown in the insulating layer 10.

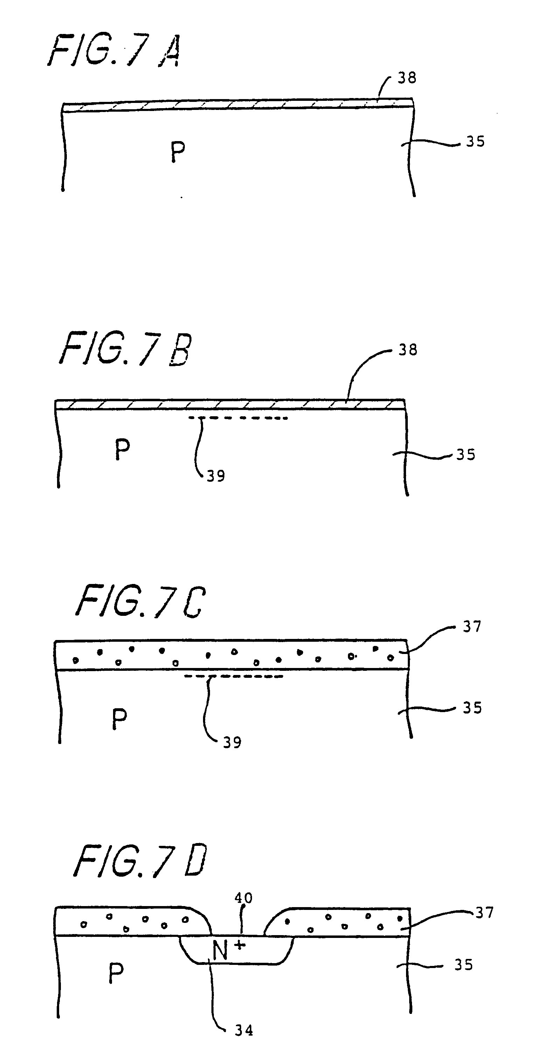

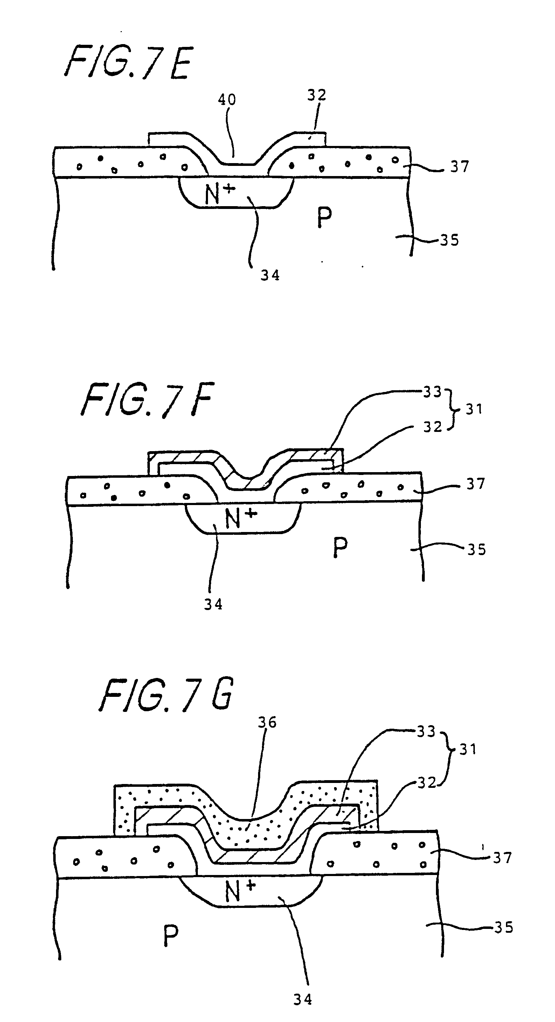

Figs. 7A to 7G are cross-sections illustrating the various steps in the process of fabricating a BIC cell according to the invention. The present invention BIC cell has a structure as shown in Fig. 7G, wherein the insulating layer 31 comprises a first dielectric film 32 and a second dielectric film 33. That is, in an embodiment according to the present invention, a double-layer-structured insulating layer is provided between a lower electrode 34, which is an $N^+$ region formed in a semiconductor substrate 35, for example, and an upper electrode 36. The first dielectric film 32 and the second dielectric film 33 are respectively formed from different dielectric materials : the first dielectric material film 32 is composed of silicon nitride ($Si_3N_4$) and the second dielectric material film 33 is composed of silicon dioxide ($SiO_2$), for example. In Fig. 7G, the reference 37 designates an insulating layer composed of a PSG (phosopho-silicate glass), for example. The PSG layer 37 is formed to cover the substrate 35 and has an opening therethrough to expose the $N^+$ region 34.

In the above, a P-type well formed in an N-type-silicon substrate may be substituted for the substrate 35. As in a prior art BIC cell, the BIC cell according to the invention as shown in Fig. 7G, is programmed by applying a voltage pulse between the electrodes 34 and 36 so as to cause a breakdown in the insulating layer 31.

The fabrication steps of the BIC cell shown in Fig. 7G will now be described. Referring to Fig. 7A, a silicon-dioxide ($SiO_2$) layer 38 having a thickness of about 20 nm, for example, is formed on a P-type single crystal silicon substrate 35 by oxidizing the substrate at about 950°C. A resist mask layer (not shown) is formed on the substrate 35 and patterned to expose a predetermined region of the substrate 35. Then, arsenic ion implantation is performed in the substrate by using the resist mask layer. Thus, arsenic atoms (As) are selectively implanted in the substrate 35, as schematically represented by a dotted line 39 in Fig. 7B. Exemplary conditions for the As ion implantation include ion energy of 100KeV and dosage of $4\times10^{15}$ ions/cm² for the As ions.

The resist mask layer (not shown) and the $SiO_2$ layer 38 are removed and another $SiO_2$ layer (not shown) having a thickness of about 20 nm is formed on the substrate 35 by using a conventional oxidation at about 950°C. Then, a PSG layer 37 having a thickness of about 1 micron is formed on substrate 35 by using a conventional CVD (chemical vapor depositon) method, for example, as shown in Fig. 7C. The PSG layer 37 is selectively removed to form a contact hole 40 to expose the As ion implanted region 39, as shown in Fig. 7D, by using a conventional dry etching method. The substrate 35 is, then, heated in an inert atmosphere such as nitrogen gas ($N_2$) for about ten minutes at 1050° so as to provide the step at the periphery of the contact hole 40 with a gentle slope. The implanted As atoms 39 are activated to form an $N^+$ region in the P-type substrate 35 during the above thermal process.

A $Si_3N_4$ film 32 having a thickness in the range between 5 and 20 nm is formed on the substrate 35 and patterned to cover the contact hole 40 as shown in Fig. 7E, and then, a $SiO_2$ film 33 having a thickness in the range between 0.5 and 10 nm is formed on the $Si_3N_4$ film 32, as shown in Fig. 7F. Preferably, the silicon nitride film 32 has a thickness larger by a factor in the range of 1 to 40 than that of the silicon-dioxide layer 33. The $SiO_2$ film 33 may be provided by oxidizing the surface of the $Si_3N_4$ film 32. Following the above, a layer of a conducting material such as a metal or a metal alloy including aluminium, molybdenum or platinum, is formed on the substrate 35 by using a conventional thin film technology, sputtering, for example, and patterned to provide a wiring layer 36. Thus, a BIC cell in accordance with the embodiment shown in Fig. 7G is fabricated. As in prior art BIC cells, the impurity diffusion region 34 may constitute a drain region of a MIS FET formed in the substrate 35.

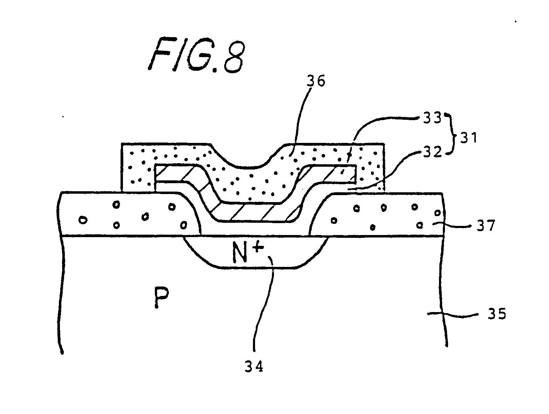

Fig. 8 shows another embodiment of a BIC cell according to the invention, wherein the $SiO_2$ film 33 is formed prior to the patterning of the $Si_3N_4$ film 32 and patterned together with the $Si_3N_4$ film 32. Each of BIC cells shown in Fig. 7G and Fig. 8 reveals desirably low programming-voltage characteristics and ON-state resistance in the programmed state. The programming voltage, i.e. the breakdown voltage of the insulating layer 31, is as low as 18 volts compared with 25 volts of the prior art BIC cell as shown in Figs.

2 or 3 with a narrow distribution such as ± 1 volt in contrast to a broad distribution such as ± 7 volts in the prior art BIC cells. The resistance of the insulating layer 31 of the programmed BIC cell is as low as 500 ohms compared with 1 kohms to 10 kohms in the prior art BIC cells.

As a variant, the insulating layer 31 of the BIC cell according to the invention may comprise an upper dielectric film 33 of $Si_3N_4$ and a lower dielectric film 32 of $SiO_2$ instead of the upper $SiO_2$ film 33 and the lower $Si_3N_4$ film 32 of Fig. 7G, or may have a triple-layer structure consisting of upper and lower $SiO_2$ films and an intermediate $Si_3N_4$ film, for example. In this last case, the upper silicon-dioxide film may be formed by partially oxydizing the intermediate silicon-nitride film.

The reason why a low and stable programming voltage is achieved in the present invention BIC cells having a composite insulating layer as described above is not elucidated yet. This may possibly be due to the low leak current characteristic of the $SiO_2$ film and the less concentration of local field in the $Si_3N_4$ film. That is, a $SiO_2$ film has a high resistivity before it is electrically broken down. On the other hand, a $Si_3N_4$ film reveals a relatively large leak current flowing therethrough. The leak current in the $Si_3N_4$ film is considered to be carried through traps existing in the $Si_3N_4$ film and serves to reduce the concentration of local field to be established due to the lattice defects in the film. Accordingly, such a breakdown at a low field strength as caused in a thin $SiO_2$ film as mentioned before is not usually revealed in $Si_3N_4$ films. However, the leak current in a $Si_3N_4$ film has so large a value as to cause an erroneous operation in a circuit comprising a number of BIC cells if the insulating layer consists only of a $Si_3N_4$ film.

A BIC cell of the present invention comprises a relatively thick $Si_3N_4$ film and a relatively thin $SiO_2$ film, wherein the relatively thick $Si_3N_4$ film withstands the operating voltage until the write-in voltage is applied thereto, and the relatively thin $SiO_2$ film prevents the leak current to flow through the BIC cell. Accordingly, it is obvious that the composite insulating layer of the present invention BIC cell is not limited to the combination such as $SiO_2/Si_3N_4$ and $SiO_2/Si_3N_4/SiO_2$ but any different insulating films having properties for exerting the same effects as those of $SiO_2$ and $Si_3N_4$ films, respectively, can be exmployed to be substituted therefor.

## Claims

1. A programmable element for a semiconductor integrated circuit chip, comprising a lower electrode layer (34) formed on a substrate (35) ; a first insulating layer (31) formed on the lower electrode layer ; and an upper electrode layer (36) formed on the first insulating layer, the upper electrode being separated from the lower electrode by the first insulating layer, whereby the programmable element is provided with a conduction path between the lower and upper electrodes when a voltage capable of causing an electrical breakdown in the first insulating layer is applied between the lower and upper electrodes, characterized in that said first insulating layer (31) is composed of at least two films (32,33) of dielectric materials, successively formed on said lower electrode layer (34), said dielectric material films having respective specific dielectric constants different from each other.

2. A programmable element according to claim 1, wherein one of said dielectric films is a silicon-nitride film (32).

3. A programmable element according to any one of claims 1 and 2, wherein one of said dielectric films is a silicon-dioxide film (33).

4. A programmable element according to any one of claims 1 to 3, wherein said first insulating layer comprises a relatively thin silicon-dioxide film (33) and a relatively thick silicon-nitride film (32).

5. A programmable element according to any one of the preceding claims, wherein one of said dielectric films is a silicon-nitride film (32) having a thickness in a range from 5 nm to 20 nm.

6. A programmable element according to any one of the preceding claims, wherein one of said dielectric films is a silicon-dioxide film (33) having a thickness in a range from 0.5 nm to 10 nm.

7. A programmable element according to any one of the preceding claims, wherein said substrate (35) is a semiconductor substrate having a conductivity type and said lower electrode (34) is an impurity diffusion layer formed in said semiconductor substrate, said impurity diffusion layer having a conductivity type opposite to that of said semiconductor substrate, and said programmable element further comprises a second insulating layer (37) formed on said semiconductor substrate, said second insulating layer having a contact hole selectively formed therein to expose said impurity diffusion layer (34), said first insulating layer (31) being formed on said contact hole so as to cover said exposed impurity diffusion layer and said conduction path is established between said impurity diffusion layer (34) and said upper electrode (36) by applying a voltage therebetween.

8. A programmable element according to claim 7, wherein said second insulating layer (37) is composed of a phospho-silicate glass.

9. A programmable element according to any one of claims 7 and 8, wherein said impurity diffusion layer (34) constitutes a drain region of a MIS FET (metal-insulator-semiconductor field-effect-transistor) formed in said semiconductor substrate.

10. A programmable element according to any one of the preceding claims, wherein said first insulating layer (31) includes a silicon-nitride film (32) and a silicon-dioxide film (33), said silicon-nitride film (32) having a thickness larger by a factor in the range from 1 to 40 than that of said silicon-dioxide film (33).

11. A programmable element according to any one of the preceding claims, wherein said first insulating layer (31) comprises an underlying silicon-nitride film (32) and an overlying silicon-dioxide film (33).

12. A programmable element according to claim 11, wherein said overlying silicon-dioxide film (33) is formed by partially oxidizing said underlying silicon-nitride layer (32).

13. A programmable element according to any one of claims 1 to 10, wherein said first insulating layer comprises an underlying silicon-dioxide film and an overlying silicon-nitride film.

14. A programmable element as set forth in claim 13, wherein said first insulating layer further comprises another silicon-oxide film formed on said overlying silicon-nitride film.

15. A programmable element as set forth in claim 14, wherein said another silicon-oxide film on said silicon-nitride film is formed by partially oxidizing said silicon-nitride film.

16. A programmable element according to any one of the preceding claims, wherein said upper electrode (36) is composed of a metal or metal alloy, including aluminium, molybdenum or platinum.

## Ansprüche

1. Programmierbares Element für ein integriertes Halbleiterschaltungschip, mit einer unteren Elektrodenschicht (34), die auf einem Substrat (35) gebildet ist ; einer ersten isolierenden Schicht (31), die auf der unteren Elektrodenschicht gebildet ist ; und einer oberen Elektrodenschicht (36), die auf der ersten isolierenden Schicht gebildet ist, welche obere Elektrode von der unteren Elektrode durch die erste isolierende Schicht getrennt ist, wodurch das programmierbare Element mit einem Leitungsweg zwischen den unteren und oberen Elektroden versehen ist, wenn eine Spannung, die einen elektrischen Durchbruch in der ersten isolierenden Schicht zu verursachen fähig ist, zwischen den unteren und oberen Elektroden aufgebracht wird,
dadurch gekennzeichnet, daß die erste isolierende Schicht (31) aus wenigstens zwei Filmen (32, 33) aus dielektrischen Materialien zusammengesetzt ist, die sukzessiv auf der genannten unteren Elektrode (34) gebildet sind, welche Filme aus dielektrischem Material jeweils spezifische dielektrische Konstanten haben, die voneinander verschieden sind.

2. Programmierbares Element nach Anspruch 1, bei dem einer der genannten dielektrischen Filme ein Siliciumnitridfilm (32) ist.

3. Programmierbares Element nach einem der Ansprüche 1 und 2, bei dem einer der genannten dielektrischen Filme ein Siliciumdioxidfilm (33) ist.

4. Programmierbares Element nach einem der Ansprüche 1 bis 3, bei dem die genannte erste isolierende Schicht einen relativ dünnen Siliciumdioxidfilm (33) und einen relativ dicken Siliciumnitridfilm (32) umfaßt.

5. Programmierbares Element nach einem der vorhergehenden Ansprüche, bei dem einer der genannten dielektrischen Filme ein Siliciumnitridfilm (32) ist, der eine Dicke im Bereich von 5 nm bis 20 nm hat.

6. Programmierbares Element nach einem der vorhergehenden Ansprüche, bei dem einer der genannten dielektrischen Filme ein Siliciumdioxidfilm (33) ist, der eine Dicke im Bereich vom 0,5 nm bis 10 nm hat.

7. Programmierbares Element nach einem der vorhergehenden Ansprüche, bei dem das genannte Substrat (35) ein Halbleitersubstrat ist, das einen Leitfähigkeitstyp hat, und die genannte untere Elektrode (34) eine Verunreinigungsdiffusionsschicht ist, die in dem genannten Halbleitersubstrat gebildet ist, die genannte Verunreinigungsdiffusionsschicht einen Leitfähigkeitstyp entgegengesetzt zu jenem des genannten Halbleitersubstrats hat, und das genannte programmierbare Element ferner eine zweite isolierende Schicht (37) umfaßt, die auf dem genannten Halbleitersubstrat gebildet ist, welche zweite isolierende Schicht ein Kontaktloch hat, das selektiv darin gebildet ist, um die genannte Verunreinigungsdiffusionsschicht (34) zu exponieren, die genannte erste isolierende Schicht (31) auf dem genannten Kontaktloch gebildet ist, um so die genannte exponierte Verunreinigungsdiffusionsschicht zu bedecken, und der genannte Leitungsweg zwischen der genannten Verunreinigungsdiffusionsschicht (34) und der genannten oberen Elektrode (36) durch Aufbringen einer Spannung dazwischen hergestellt wird.

8. Programmierbares Element nach Anspruch 7, bei dem die genannte zweite isolierende Schicht (37) aus einem Phosphorsilikatglas besteht.

9. Programmierbares Element nach einem der Ansprüche 7 und 8, bei dem die genannte Verunreinigungsdiffusionsschicht (34) einen Drainbereich eines MIS-FET-(Metall-Isolator-Halbleiter-Feldeffekttransistors) bildet, der in dem genannten Halbleitersubstrat gebildet ist.

10. Programmierbares Element nach einem der vorhergehenden Ansprüche, bei dem die genannte isolierende Schicht (31) einen Siliciumnitridfilm (32) und einen Siliciumdioxidfilm (33) umfaßt, der genannte Siliciumnitridfilm (32) eine Dicke hat, die um einen Faktor im Bereich von 1 bis 40 größer als jene des genannten Siliciumdioxidfilms (33) ist.

11. Programmierbares Element nach einem der vorhergehenden Ansprüche, bei dem die genannte erste isolierende Schicht (31) einen unten liegenden Siliciumnitridfilm (32) und einen oben liegenden Siliciumdioxidfilm (33) umfaßt.

12. Programmierbares Element nach Anspruch 11, bei dem der genannte oben liegende Siliciumdioxidfilm (33) durch teilweises Oxidieren der genannten unten liegenden Siliciumnitridschicht (32) gebildet ist.

13. Programmierbares Element nach einem der Ansprüche 1 bis 10, bei dem die genannte erste isolierende Schicht einen unten liegenden Siliciumdioxidfilm und einen oben liegenden Siliciumnitridfilm umfaßt.

14. Programmierbares Element nach Anspruch 13, bei dem die genannte erste isolierende Schicht ferner einen anderen Siliciumoxidfilm umfaßt, der auf dem genannten oben liegenden Silicumnitridfilm gebildet ist.

15. Programmierbares Element nach Anspruch 14, bei dem der genannte andere Siliciumoxidfilm auf dem genannten Siliciumnitridfilm durch teilweises Oxidieren des genannten Siliciumnitridfilms gebildet ist.

16. Programmierbares Element nach einem der vorhergehenden Ansprüche, bei dem die genannte obere Elektrode (36) aus einem Metall oder einer Metallegierung einschließlich Aluminium, Molybdän oder Platin gebildet ist.


**Revendications**

1. Elément programmable pour puce à circuit intégré semiconducteur, comprenant une couche d'électrode inférieure (34) formée sur un substrat (35) ; une première couche isolante (31) formée sur la couche d'électrode inférieure ; et une couche d'électrode supérieure (36) formée sur la première couche isolante, l'électrode supérieure étant séparée de l'électrode inférieure par la première couche isolante, si bien que l'élément programmable est doté d'un trajet de conduction entre les électrodes inférieure et supérieure lorsqu'une tension susceptible de provoquer une rupture électrique dans la première couche isolante est appliquée entre les électrodes supérieure et inférieure,
caractérisé en ce que ladite première couche isolante (31) est constituée d'au moins deux pellicules (32, 33) de matériaux diélectriques, qui sont successivement formées sur ladite couche d'électrode inférieure (34), lesdites pellicules de matériaux diélectriques ayant des constantes diélectriques spécifiques qui sont respectivement différentes l'une de l'autre.

2. Elément programmable selon la revendication 1, où l'une desdites pellicules diélectriques est une pellicule de nitrure de silicium (32).

3. Elément programmable selon l'une quelconque des revendications 1 et 2, où l'une desdites pellicules diélectriques est une pellicule de dioxyde de silicium (33).

4. Elément programmable selon l'une quelconque des revendications 1 à 3, où ladite première couche isolante comprend une pellicule de dioxyde de silicium relativement mince (33) et une pellicule de nitrure de silicium relativement épaisse (32).

5. Elément programmable selon l'une quelconque des revendications précédentes, où l'une desdites pellicules diélectriques est une pellicule de nitrure de silicium (32) possédant une épaisseur comprise dans l'intervalle de 5 nm à 20 nm.

6. Elément programmable selon l'une quelconque des revendications précédentes, où l'une desdites pellicules diélectriques est une pellicule de dioxyde de silicium (33) ayant une épaisseur comprise dans l'intervalle de 0,5 nm à 10 nm.

7. Elément programmable selon l'une quelconque des revendications précédentes, où ledit substrat (35) est un substrat semiconducteur possédant un certain type de conductivité et ladite électrode inférieure (34) est une couche de diffusion d'impureté formée dans ledit substrat semiconducteur, ladite couche de diffusion d'impureté ayant un type de conductivité opposé à celui dudit substrat semiconducteur, et ledit élément programmable comprend en outre une deuxième couche isolante (37) formée sur ledit substrat semiconducteur, ladite deuxième couche isolante possédant un trou de contact sélectivement formé dans celle-ci de façon à exposer ladite couche de diffusion d'impureté (34), ladite première couche isolante (31) étant formée sur ledit trou de contact de façon à couvrir ladite couche de diffusion d'impureté exposée et ledit trajet de conduction est établi entre ladite couche de diffusion d'impureté (34) et ladite électrode supérieure (36) par application d'une tension entre celles-ci.

8. Elément programmable selon la revendication 7, où ladite deuxième couche isolante (37) est constituée par un verre de phosphosilicate.

9. Elément programmable selon l'une quelconque des revendications 7 et 8, où ladite couche de diffusion d'impureté (34) constitue la région de drain d'un FET MIS (transistor à effet de champ métal-isolant-semiconducteur) formé dans ledit substrat semiconducteur.

10. Elément programmable selon l'une quelconque des revendications précédentes, où ladite première couche isolante (31) comporte une pellicule de nitrure de silicium (32) et une pellicule de dioxyde de silicium (33), ladite pellicule de nitrure de silicium (32) ayant une épaisseur plus grande, d'un facteur compris entre 1 et 40, que celle de ladite pellicule de dioxyde de silicium (33).

11. Elément programmable selon l'une quelconque des revendications précédentes, où ladite première couche isolante (31) comprend une pellicule de nitrure de silicium située au-dessous (32) et une pellicule de dioxyde de silicium située au-dessus (33).

12. Elément programmable selon la revendication 11, où ladite pellicule de dioxyde de silicium située au-dessus (33) est formée par oxydation partielle de ladite pellicule de nitrure de silicium située au-dessous (32).

13. Elément programmable selon l'une quelconque des revendications 1 à 10, où ladite première couche isolante comprend une pellicule de dioxyde de silicium située au-dessous et une pellicule de nitrure de silicium située au-dessus.

14. Elément programmable selon la revendication 13, où ladite première couche isolante comprend en outre une autre pellicule d'oxyde de silicium formée sur ladite pellicule de nitrure de silicium située au-dessus.

15. Elément programmable selon la revendication 14, où ladite autre pellicule d'oxyde de silicium se trouvant sur ladite pellicule de nitrure de silicium est formée par oxydation partielle de ladite pellicule de nitrure de silicium.

16. Elément programmable selon l'une quelconque des revendications précédentes, où ladite électrode supérieure (36) est constituée d'un métal ou d'un alliage de métal, comprenant l'aluminium, le molybdène ou le platine.

# FIG. 1  PRIOR ART

# FIG. 2  PRIOR ART

## FIG. 3    PRIOR ART

## FIG. 4

## FIG. 5

## FIG. 6

## FIG. 7 A

38
35
P

## FIG. 7 B

38
35
P
39

## FIG. 7 C

37
35
P
39

## FIG. 7 D

40
37
35
P
N⁺
34

11

FIG.7 E

FIG.7 F

FIG.7 G

# FIG.8